# DEMANDE DE BREVET EUROPEEN

(11) **EP 1 389 782 A1**
(43) Date de publication de la demande: **18.02.2004**
(21) Numéro de dépôt: 03366006.9
(22) Date de dépôt: 04.08.2003
(51) Int. Cl.: G11C 17/16, G11C 17/18

(54) **Procédé de programmation d'un anti-fusible et circuit de programmation associé**

(30) Priorité: 12.08.2002 FR 0210195
(71) Demandeur: STMicroelectronics S.A., 92120 Montrouge (FR)
(72) Inventeur: La désignation de l'inventeur n'a pas encore été déposée
(74) Mandataire: Bentz, Jean-Paul

(57) **Abrégé**

L'invention concerne un procédé de programmation d'un transistor anti-fusible (100) comprenant d'une part un drain (102), une source (103) et un caisson (101) connectés ensemble et d'autre part une grille (104).

Selon l'invention, on applique un potentiel élevé (HT) sur le drain (102) du transistor anti-fusible (100) et un potentiel de référence (VSS) sur la grille (104) du transistor anti-fusible (100).

L'invention concerne également un circuit comprenant un transistor anti-fusible (100), et un premier transistor d'accès (110) comprenant une source sur laquelle est appliqué un potentiel élevé (HT) et un drain connecté à la source (103) du transistor anti-fusible (100)

## Description

L'invention concerne un procédé de programmation d'un anti-fusible, et un circuit de programmation associé. L'invention peut être utilisée dans tout type de circuit électronique dans lequel on utilise un anti-fusible.

Un anti-fusible est un composant programmable une seule fois, qui est équivalent à un circuit ouvert par défaut lors de sa fabrication, et qui est équivalent à un conducteur lorsqu'il est programmé.

Les anti-fusibles sont utilisés dans un très grand nombre d'applications. Ils peuvent être utilisés par exemple pour la personnalisation d'un composant en sortie de chaîne de production, pour mémoriser de manière indélébile une information (par exemple un code identifiant) dans le composant. ILs peuvent également être utilisés pour ajuster une variable (la valeur d'une résistance, d'une tension produite, etc.) d'un composant après une phase de test.

Par rapport à une cellule de mémorisation de type EEPROM, autre circuit de mémorisation classique, les anti-fusibles sont notamment appréciés pour leur caractère indélébile, leur petite taille, et le fait qu'ils peuvent être lus immédiatement car ils ne nécessitent pas l'utilisation d'une haute tension pour cela, comme on le verra plus loin.

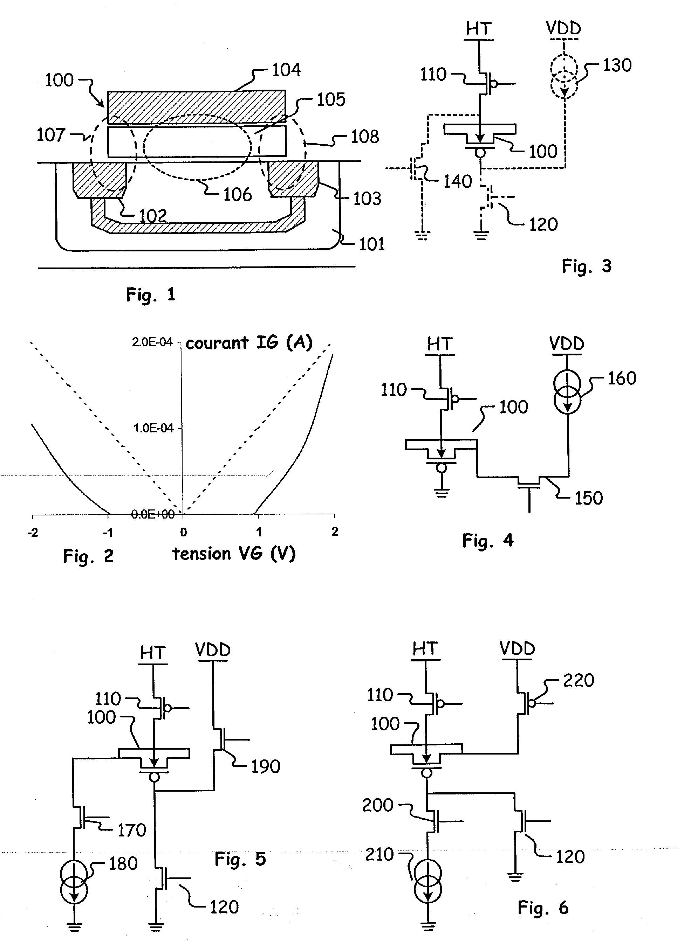

Un anti-fusible peut être réalisé comme un condensateur. Dans un exemple (figure 1), un anti-fusible 100 est réalisé sous la forme d'un transistor de type P, réalisé dans un caisson 101 de type N comprenant une zone de drain 102 et une zone de source 103. La grille 104 du transistor est isolée du caisson 101 et des zones de drain 102 et de source 103 par une couche d'oxyde mince 105 isolant (oxyde de silicium). Le caisson 101, la zone de drain 102 et la zone de source 103 sont portés au même potentiel. Les zones de source 102 et de drain 103 d'une part et la grille 104 d'autre part forment les deux armatures d'un condensateur dont l'isolant est formé par l'oxyde de grille mince 105.

L'anti-fusible représenté figure 1 n'est pas programmé. Entre la grille 104 et la source 103 (ou le drain 102) du transistor formant l'anti-fusible 100, l'impédance est infinie lorsque le transistor est bloqué, l'anti-fusible est équivalent à un circuit ouvert.

Pour programmer un tel anti-fusible, une solution connue est d'utiliser la méthode dite de « claquage par accumulation » : on perce l'oxyde de grille 105, en appliquant, de manière connue, un potentiel élevé HT (environ 10,5 V, pour un anti-fusible réalisé avec un oxyde de grille de 50 Angström d'épaisseur) sur la grille 104, tout en appliquant un potentiel de référence (0 V) sur le drain 102, la source 103 et le caisson 101. On attire ainsi peu à peu des électrons qui se répartissent sous la zone d'oxyde de grille 105. En conséquence, le champ sous l'oxyde de grille augmente peu à peu, de manière homogène entre le drain et la source de l'anti-fusible, jusqu'au claquage ou perçage de l'oxyde de grille en une zone 106 située entre la source et le drain de l'anti-fusible. L'oxyde de grille percé devient localement conducteur, au niveau de la zone percée. Entre la grille et la source du transistor, l'impédance devient alors finie. L'anti-fusible est programmé.

Pour "lire" l'anti-fusible c'est-à-dire déterminer s'il est programmé ou pas, on mesure l'impédance entre la grille et la source du transistor. La lecture peut se faire en appliquant une tension entre la grille et la source du transistor formant l'anti-fusible et en mesurant le courant circulant entre la grille et la source. La lecture peut également être faite en imposant un courant entre la grille et la source du transistor et en mesurant la tension entre la grille et la source.

La méthode de programmation connue présente certains inconvénients, car l'impédance obtenue après programmation entre la grille et la source du transistor 100 formant l'anti-fusible est très variable et est, de ce fait, difficile à mesurer.

L'impédance de l'anti-fusible programmé est en effet fortement non linéaire (courbe en trait plein, figure 2) ; elle varie de manière non négligeable avec la tension appliquée entre la grille 104 et la source 103 du transistor 100 anti-fusible. Un tel comportement pour une impédance est typique d'une jonction P/ N, qui caractérise le contact entre le caisson 101 de type N et la grille 104 de type P, localement là où l'oxyde isolant 105 a été percé.

En pratique, lorsque la tension VG entre la grille et la source est faible, comprise entre -1 et 1 V, l'impédance est infinie (y compris lorsque l'anti-fusible est programmé) ; l'impédance n'est pas détectable. Il faut donc une tension VG minimale de l'ordre de 1 V pour détecter si l'anti-fusible est programmé ou pas. Ceci est assez contraignant, notamment pour les circuits réalisés dans les technologies les plus fines et qui utilisent des tension d'alimentation de l'ordre de 1 V.

L'impédance de l'anti-fusible programmé varie également fortement avec la température du composant. Le courant ou la tension à détecter entre la grille et la source de l'anti-fusible programmé pour mesurer l'impédance varie donc également avec la température. Un circuit de lecture apte à détecter de tels courants ou tensions variables avec la température est particulièrement difficile à réaliser.

Enfin, l'impédance de l'anti-fusible programmé varie fortement d'un composant à l'autre sur une même chaîne de fabrication. Il est là encore difficile de réaliser des circuits de lecture adaptés pour fonctionner sur une large plage de courant ou de tension.

L'invention a pour but de résoudre les problèmes évoqués ci-dessus, en proposant notamment un procédé et un circuit associé de programmation d'un anti-fusible, qui conduit à l'obtention d'un anti-fusible présentant, lorsqu'il est programmé, une impédance parfaitement résistive.

Avec cet objectif en vue , l'invention concerne un procédé de programmation d'un transistor anti-fusible comprenant d'une part un drain, une source et un caisson connectés ensemble et d'autre part une grille.

Selon l'invention, on applique un potentiel de référence sur la grille du transistor anti-fusible et un potentiel élevé sur le drain du transistor anti-fusible.

En d'autre terme, selon l'invention, pour programmer le transistor anti-fusible, on applique, entre la grille et la source (connectée au drain et au caisson) du transistor anti-fusible, une tension inverse de celle qui est appliquée dans la méthode de programmation connue de l'art antérieur.

Le potentiel élevé est un potentiel de programmation, supérieur au potentiel d'alimentation du circuit.

Avec l'invention, comme on le verra mieux par la suite, et contrairement à la méthode de programmation connue, le perçage de la couche d'oxyde mince a lieu au niveau de la zone de source et de la zone de drain du transistor anti-fusible. Ainsi, après perçage de l'oxyde, la grille et la source sont localement en contact. De même, la grille et le drain sont également en contact. Comme le drain, la source et la grille sont réalisés dans le même matériau, les contacts obtenus après programmation sont résistifs, et donc notamment indépendants de la tension entre la grille et la source. L'impédance résultante est donc beaucoup plus facile à détecter.

De préférence, selon l'invention, pour appliquer le potentiel élevé sur le drain du transistor anti-fusible, on rend passant un premier transistor d'accès dont un drain est connecté au drain du transistor anti-fusible, le potentiel élevé étant appliqué sur la source du premier transistor d'accès.

Ainsi, le potentiel élevé est appliqué sur le drain du transistor anti-fusible uniquement lorsqu'une programmation est souhaitée, et le transistor anti-fusible est isolé du potentiel élevé si aucune programmation n'est en cours.

L'invention concerne également un circuit comprenant un transistor anti-fusible comprenant d'une part un drain, une source et un caisson connectés ensemble, et d'autre part une grille.

Le circuit selon l'invention comprend également un premier transistor d'accès comprenant une source sur laquelle est appliqué un potentiel élevé et un drain connecté à la source du transistor anti-fusible. Un potentiel de référence inférieur au potentiel élevé est appliqué sur la grille du transistor anti-fusible.

De préférence, le circuit comprend également un deuxième transistor d'accès comprenant un drain connecté à la grille du transistor anti-fusible, et une source sur laquelle est appliquée un potentiel de référence.

L'invention et les avantages qui en découlent apparaîtront plus clairement à la lecture de la description qui suit d'exemples de réalisation d'un circuit anti-fusible et d'exemples de mise en oeuvre du procédé, selon l'invention. La description est à lire en référence aux dessins annexés dans lesquels :
- la figure 1, déjà décrite, est un schéma en coupe d'un anti-fusible en technologie CMOS,
- la figure 2 montre l'évolution des signaux aux bornes d'un anti-fusible programmé
- la figure 3 est un schéma électronique d'un circuit anti-fusible selon l'invention,
- les figures 4 à 6 sont des variantes du schéma de la figure 3.

Le transistor anti-fusible 100 de la figure 1 est représenté sous une autre forme figure 3. Le transistor 100 comprend une grille sur laquelle est appliqué un potentiel de référence VSS. Le transistor 100 comprend également un drain, une source et un caisson connectés ensemble à un drain d'un premier transistor d'accès 110. Selon l'invention, un potentiel élevé HT est appliqué sur la source du transistor 110 et un signal de validation PROG (non représenté figure 2) est appliqué sur la grille du transistor 110. Dans un exemple , le potentiel HT et égal à 10,5 V pour un anti-fusible réalisé avec un oxyde de grille de 50 Angström d'épaisseur.

Le circuit de la figure 3 permet de programmer l'antifusible 100 en réalisant, selon l'invention, un claquage en inversion de l'oxyde de grille 105 : on applique le potentiel HT élevé sur la source du transistor 100 lorsqu'il est passant, son drain 102 et sa source 103 étant au potentiel de référence. La grille du transistor 100 étant connectée à la masse, une différence de potentiel (ou tension) importante apparaît entre d'une part la grille 104 de l'anti-fusible 100 et d'autre part son drain 102 et sa source 103. Comme le caisson 101 est au potentiel de référence et la grille 104 au potentiel élevé HT, les trous majoritaires sont repoussés vers le caisson et une légère couche d'inversion apparaît, répartie sous la couche d'oxyde 105. Les régions les plus dopées en trous sont le drain 102 et la source 103 du transistor 100 anti-fusible. Aussi, le champ électrique augmente plus fortement au niveau des zones 107, 108 représentées en tirets, figure 1), proches des zones de drain 102 et de source 103 de l'anti-fusible 100.

Lorsque le champ atteint une valeur suffisante au niveau des zones 107, 108, l'oxyde de grille 105 est percé, préférentiellement au niveau des zones où le champ est le plus fort, c'est-à-dire au niveau des zones 107, 108. Après claquage, la grille 104, en poly silicium P+, vient en contact avec la couche inférieure, au niveau où l'oxyde de grille 105 est percé, ici les zones de drain 102 et de source 105, en poly silicium P+. Les zones de grille 104 et de drain 102 et / ou de source 103 en contact étant du même type, le comportement de la jonction ainsi formé est de type résistif. Il s'ensuit un comportement résistif de l'impédance de l'anti-fusible programmé.

Une telle impédance résistive est bien sûr beaucoup plus facile à détecter que l'impédance d'un anti-fusible programmé selon les méthodes connues de l'art antérieur. En effet, une impédance résistive, telle que celle obtenue par une programmation selon l'invention, a l'avantage d'être indépendante de la tension ; la courbe montrant l'évolution du courant circulant entre la grille et la source du transistor anti-fusible en fonction de la tension entre la grille et la source est donc linéaire (voir courbe en pointillés figure 2). Une telle impédance résistive a de plus l'avantage d'être beaucoup moins sensible à la température et aux variations de procédé de fabrication. Une telle impédance résistive est donc beaucoup plus facile à détecter, y compris pour de faibles tensions de mesure, entre la grille et la source de l'anti-fusible.

Le circuit de la figure 3 est avantageusement complété par un deuxième transistor d'accès 120 (représenté en tirets-points figure 2), dont le drain et la source sont connectés entre la grille du transistor 100 et la masse du circuit. Le transistor 120 permet d'isoler l'anti-fusible 100 de la masse du circuit en dehors de l'instant de sa programmation. Le transistor 120 est rendu passant en même temps que le transistor 110.

Le circuit comprenant l'anti-fusible 100 est également avantageusement complété par des éléments permettant la lecture de l'anti-fusible, à tout moment.

Selon un premier mode de réalisation, figure 3, le circuit comprend également une source de courant 130 et un troisième transistor d'accès 140 (en pointillés figure 3). La source de courant 130 comprend un pôle connecté à la grille du transistor anti-fusible 100 et un autre pôle sur lequel est appliqué un potentiel d'alimentation VDD. Le drain et la source du transistor 140 sont connectés respectivement à la source de l'anti-fusible 100 et à la masse. Le transistor 140 est commandé par un signal de lecture READ (non représenté figure 3). Les éléments 130, 140, permettent de réaliser une lecture en accumulation de l'antifusible 100. Lorsque le signal READ est actif, le transistor 140 est passant, le courant IG produit par la source de courant 130 circule entre la grille et la source de l'anti-fusible.

Une mesure de la tension VG entre la grille et la source de l'anti-fusible 100 permet d'obtenir immédiatement son impédance : ZG = VG / IG. Si cette impédance est infinie, alors l'anti-fusible est non programmé. Inversement, si cette impédance est finie, alors l'anti-fusible est programmé.

On notera ici un des avantages d'un anti-fusible par rapport à un circuit de mémorisation tel qu'un circuit EEPROM. Le potentiel VDD d'alimentation du circuit est suffisant pour lire l'anti-fusible. Par exemple, VDD = 1,65 V pour un circuit réalisé en technologie 0,18 µm. Il n'est pas nécessaire de disposer d'un potentiel plus élevé.

Les figures 4 à 6 présentent des variantes de la figure 3. Tous ces circuits fonctionnent de manière similaire. Tous comprennent un anti-fusible 100, des moyens pour sa programmation et des moyens pour sa lecture. Selon l'invention, la programmation est réalisée en inversion, avec les transistors 110, 120.

Sur la figure 4, pour lire l'anti-fusible, on utilise un transistor d'accès 150 et une source de courant 160 connectés en série entre la source de l'anti-fusible 100 et la source de potentiel d'alimentation VDD, la grille de l'anti-fusible étant quant à elle connectée à la masse du circuit. Le transistor 110est rendu passant par le signal de programmation PROG lorsqu'une programmation du transistor anti-fusible 100 est souhaitée. Le transistor 150 est quant à lui rendu passant par le signal de lecture READ lorsqu'une lecture est souhaitée. Le circuit figure 4 réalise une lecture en inversion.

Sur la figure 5, pour lire l'anti-fusible 100, on utilise un transistor d'accès 170 et une source de courant 180 connectés en série entre la source de l'anti-fusible et la masse. On utilise également un transistor d'accès 190 connecté entre la grille de l'anti-fusible 100 et la source fournissant le potentiel d'alimentation VDD. Les transistors 170, 190 sont rendus passants par le signal de lecture READ lorsqu'une lecture est souhaitée. Les transistors d'accès 170, 190 permettre d'isoler l'anti-fusible de la masse et de la source de potentiel VDD lorsque aucune lecture n'est envisagée. On réalise ainsi une lecture en accumulation.

Enfin, sur la figure 6, pour lire l'anti-fusible 100, on utilise un transistor d'accès 200 et une source de courant 210 connectés en série entre la grille de l'anti-fusible et la masse. On utilise également un transistor d'accès 220 connecté entre la source de l'anti-fusible 100 et la source fournissant le potentiel d'alimentation VDD. Les transistors 110, 120 sont rendus passants lorsqu'une programmation de l'anti-fusible 100 est souhaitée. Les transistors 200, 220 sont quant à eux rendus passants lorsqu'une lecture est souhaitée. On réalise ainsi une lecture en inversion.

## Revendications

1. Procédé de programmation d'un transistor anti-fusible (100) comprenant d'une part un drain (102), une source (103) et un caisson (101) connectés ensemble et d'autre part une grille (104), le procédé étant **caractérisé en ce qu'**on applique un potentiel de référence (VSS) sur la grille (104) du transistor anti-fusible (100) et un potentiel élevé (HT) supérieur au potentiel de référence sur le drain (102) du transistor anti-fusible (100).

2. Procédé selon la revendication 1, **caractérisé en ce que**, pour appliquer le potentiel élevé (HT) sur le drain (102) du transistor anti-fusible (100), on rend passant un premier transistor d'accès (110) dont un drain est connecté au drain du transistor anti-fusible (100), le potentiel élevé étant appliqué sur la source du premier transistor d'accès (110).

3. Circuit comprenant un transistor anti-fusible (100) comprenant d'une part un drain (102), une source (103) et un caisson (101) connectés ensemble, et d'autre part une grille (104), **caractérisé en ce qu'**il comprend également un premier transistor d'accès (110) comprenant une source sur laquelle est appliqué un potentiel élevé (HT) pendant une phase de programmation et un drain connecté à la source (103) du transistor anti-fusible (100) sur la grille duquel est appliqué un potentiel de référence inférieur au potentiel élevé.

4. Circuit selon la revendication 4, comprenant également un deuxième transistor d'accès (120) comprenant un drain connecté à la grille (104) du transistor anti-fusible (100), et une source sur laquelle est appliquée un potentiel de référence (VSS).

5. Circuit selon l'unes des revendications 3 ou 4, comprenant également :
- une source de courant (130) comprenant un premier pôle connecté à la grille (104) du transistor anti-fusible (100), et un deuxième pôle sur lequel est appliqué un potentiel d'alimentation (VDD), et
- un troisième transistor d'accès (140) comprenant un drain et une source connectés entre la source (103) du transistor anti-fusible (100) et une masse du circuit.

6. Circuit selon l'une des revendications 3 ou 4, comprenant également :
- un quatrième transistor d'accès (150) comprenant une source connectée à la source (103) du transistor anti-fusible (100), et
- une source de courant (160) comprenant un premier pôle connecté au drain du quatrième transistor d'accès (150), et un deuxième pôle sur lequel est appliqué un potentiel d'alimentation (VDD).

7. Circuit selon l'une des revendications 3 ou 4, comprenant également :
- un cinquième transistor d'accès (170) comprenant un drain connecté à la source (103) du transistor anti-fusible (100),
- une source de courant (180) comprenant un premier pôle connecté à la source du cinquième transistor d'accès (170), et un deuxième pôle connecté à une masse du circuit, et
- un sixième transistor d'accès (190) comprenant une source connectée à la grille du transistor anti-fusible (100) et un drain sur lequel est appliqué le potentiel d'alimentation (VDD).

8. Circuit selon l'une des revendications 3 ou 4, comprenant également :
- un septième transistor d'accès (200) comprenant un drain connecté à la grille du transistor anti-fusible (100),
- une source de courant (210) comprenant un premier pôle connecté à la source du septième transistor d'accès (200), et un deuxième pôle connecté à une masse du circuit, et
- un huitième transistor d'accès (220) comprenant un drain connecté à la source du transistor anti-fusible (100) et une source sur laquelle est appliquée le potentiel d'alimentation (VDD).
